# EUROPEAN PATENT APPLICATION

(11) **EP 1 130 372 A1**
(43) Date of publication of application: **05.09.2001**
(21) Application number: 00104352.0
(22) Date of filing: 02.03.2000
(51) Int. Cl.: G01K 5/48, H01L 21/66

(54) **Arrangement and method for temperature measurement of a semiconductor wafer**

(71) Applicant: Semiconductor 300 GmbH & Co. KG, 01099 Dresden (DE)
(72) Inventor: Storbeck, Olaf, 01099 Dresden (DE)
(74) Representative: Fischer, Volker, Dipl.-Ing.

(57) **Abstract**

An arrangement for for temperature measurement of a semiconductor disk comprises a clamping device (2) for holding the disk (1), at least two digital camera monitoring systems (3) for locating edges of said disk (1). A data processing unit (4) is connected to the digital camera monitoring systems (3) for monitoring disk edge movement. The digital camera monitoring systems (3) are placed in the clamping device (2) and in different positions of the clamping device (2). The digital camera monitoring systems (3) face towards the disk (1). The clamping device (2) further has transparent windows (5) being placed in the surface of the clamping device (2) which is turned towards the disk (1). With this arrangement disk dimensional growth due to disk heating during a manufacturing process can be measured in order to derive disk temperature. Thus, a precise disk temperature measurement with real time data acquisition can be performed.

## Description

The present invention relates to an arrangement for temperature measurement of a semiconductor disk comprising a clamping device for holding the disk, and to a method for temperature measurement of the semiconductor disk.

In the technical field of manufacturing of semiconductor devices the semiconductor devices usually are formed like disks containing semiconductive material like silicon. For example, the disks are formed as wafers for producing semiconductor chips or as flat panels on the basis of silicon glass for producing display systems. In the manufacturing process, generally the disks are clamped by a clamping device such as a wafer chuck for holding the disks.

In the process of manufacturing of e.g. a semiconductor wafer it is common and necessary to apply various process steps to the wafer. With certain process techniques the wafer gets heated e.g. in processes where ion bombardement or plasma etching is applied. For example, during plasma etching the energy of the plasma is transferred partly to the wafer causing wafer heating. In certain processes, the wafer heating caused during a process is unintended. In order to remove unintended heat from the wafer, usually the clamping device or respective wafer chuck is cooled e.g. by water.

In particular for preventing damages or process failures, the wafer temperature is a process parameter which needs to be monitored and/or controlled during a manufacturing process. In a relative low temperature range of 50°C to 500°C common measurement techniques are not quite suitable. Current technology using e.g. thermoelements typically has a temperature lag between the wafer temperature and the measurement point of the cooling water return loop. Technologies using detectors for detecting radiation emitted by the heated wafer have to deal with the problem that due to relative low temperatures there is only a relative low amount of radiation to be detected. Therefore, the existing technologies usually comprise a relative small accuracy.

In view of the prior art, it is an object of the present invention to provide an arrangement for temperature measurement of a semiconductor disk comprising a clamping device for holding the disk, the arrangement being suitable for precise measuring of relative low disk temperatures during a manufacturing process.

Further, it is an object of the present invention to provide a method for performing precise measurement of relative low disk temperatures.

The object regarding the arrangement is solved by an arrangement for temperature measurement of a semiconductor disk comprising a clamping device for holding said disk, at least two digital camera monitoring systems for locating edges of said disk, a data processing unit connected to said digital camera monitoring systems for monitoring disk edge movement, said digital camera monitoring systems being placed in said clamping device and in different positions of said clamping device, said digital camera monitoring systems facing towards said disk, said clamping device having transparent windows being placed in the surface of said clamping device which is turned towards said disk, so that the edges of the disk can be located by said digital camera monitoring systems.

The object regarding the method is solved by a method for temperature measurement of a semiconductor disk using the aforementioned arrangement, comprising the steps of:
- calibrating the arrangement to compensate for an offset of disk dimensions and disk placement,
- locating edges of said disk with said digital camera monitoring systems,
- monitoring present disk edge movement,
- producing data from said digital camera monitoring systems containing information about disk edge movement and
- processing said data in order to derive disk temperature information.

Further advantageous features, aspects and details of the invention are evident from the dependent claims.

The provided arrangement is applicable to various disks containing semiconductive material like silicon, such as wafers for manufacturing semiconductor chips or flat panels on the basis of silicon glass for producing display systems. The provided arrangement is preferably applicable to wafers with at least 300 millimeter in diameter due to relative large dimensions.

The provided arrangement is suitable for temperature measurement of a disk being clamped by e.g. an electrostatic, physical clamping or vacuum clamping device for holding the disk. With the digital camera monitoring systems and the connected data processing unit, disk dimensional growth due to disk heating can be observed or monitored. Therefore, the edges of the disk are located. Thereafter, a present disk edge movement is monitored and data of the digital camera monitoring systems which contains information about disk edge movement is processed. With this information, after appropriate calibration processing, the disk temperature can be derived. There are at least two digital camera monitoring systems necessary being placed in different, preferably opposite, positions in the clamping device to compensate e.g. for an offset of the disk dimensions or disk placement.

If the absolute loading temperature of the disk is obtained before starting the manufacturing process, the absolute temperature during the manufacturing process can be calculated and monitored by processing the absolute loading temperature together with the data about disk edge movement.

With the provided arrangement, real time data acquisition is possible. Compared with measurement techniques using thermoelements, disk dimensional growth due to disk heating usually has relative low retardation times in relation to the actual temperature. Also, precise temperature measurement of relatively low temperatures in the range of about 50 °C to 500 °C is possible.

For protection of the complete digital camera monitoring systems each of the clamping devices has transparent windows of a material suitable for the applied environmental conditions, e.g. sapphire or quartz.

Advantageously, CCD (Charged Coupled Device) camera technology is used for the digital camera monitoring systems. With a monitoring device of a CCD type comprising a CCD-chip and accompanying electronics, there could be achieved sufficient resolution at relatively low costs with using standard CCD elements.

Preferably, each of the digital camera monitoring systems comprise an optical lens system for enlarging the projections. For example, an enlargement of about 10 to 50 times in an application using wafers of at least 300 mm in diameter will lead to sufficient resolution for measuring 1 K temperature rise or fall with standard CCD elements.

According to an embodiment of the invention, the clamping device is temperature-controlled by a controlling device comprising a heat carrier performing heat transport from or to the disk. As a heat carrier there is preferably used water usually for cooling the clamping device such as a wafer chuck. With the accurate temperature measured and monitored by the arrangement, the controlling device, e.g. a cooling circuit with appropriate regulating valves and means for controlling the regulating valves, can be controlled manually or automatically. So, an appropriate temperature of the disk can be adjusted.

In a further embodiment, the data processing unit is connected to the controlling device performing a closed-loop temperature control system. With this arrangement, an automatic temperature control system is performed for precisely controlling e.g. the so-called wafer bulk temperature.

To improve the measuring functionality of the arrangement, the arrangement comprises a light emitting source for illuminating the surface of the disk opposite to the digital camera monitoring systems. For a proper measurement result, there is necessary a sufficient amount of light emitted towards the camera monitoring systems next to the disk edges. Especially, the light emitting source is necessary during processes in which there isn't emitted a sufficient amount of light e.g. from the processing gases.

The invention will be better understood by reference to the following description of embodiments of the invention taking in conjunction with the accompanying drawings, wherein
- Figure 1: shows an embodiment of the invention,
- Figure 2: shows a more detailed view of an embodiment of the invention.

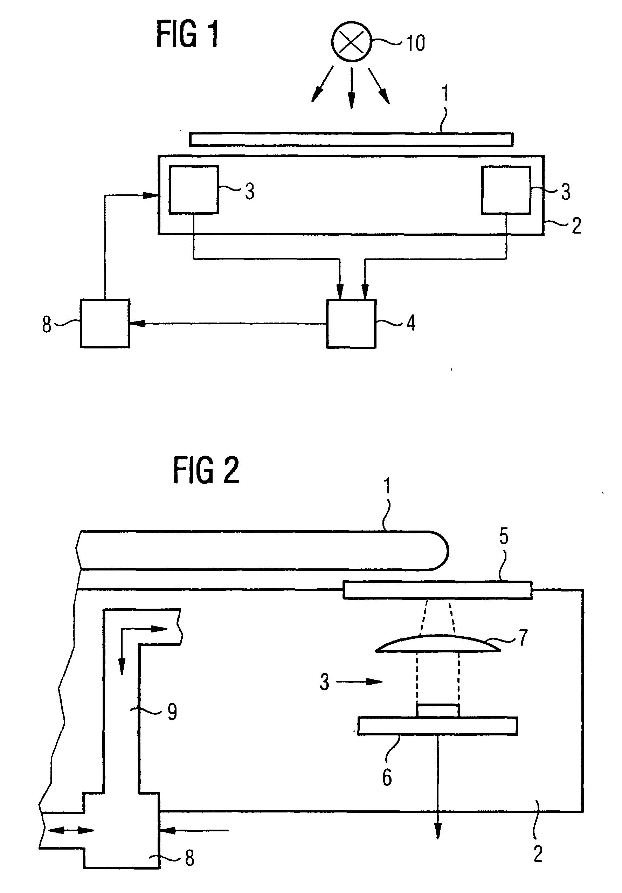

Figure 1 shows an arrangement for temperature measurement of a semiconductor disk such as a wafer 1, which is preferably circular shaped, and a clamping device 2 formed as a wafer chuck. The arrangement further comprises two digital camera monitoring systems 3 for locating the edges of the wafer 1 and a data processing unit 4 connected to the digital camera monitoring systems 3 for monitoring a present disk edge movement. The digital camera monitoring systems 3 are placed in the wafer chuck 2 and in different positions of the wafer chuck 2, here in opposite or diametrical positions, respectively. The digital camera monitoring systems 3 are facing towards the wafer 1.

Figure 2 shows a more detailed view of the arrangement illustrated in figure 1. For each of the digital camera monitoring systems 3, the wafer chuck 2 has a transparent window 5 being placed in the surface of the chuck 2 which is turned towards the wafer 1, so that the edges of the wafer 1 can be located by the camera monitoring systems 3. Each of the windows 5 is formed of a material suitable for the applied environmental conditions. Therefore, the windows 5 are formed of e.g. sapphire (Al₂O₃) or quartz (SiO₂). Each of the digital camera monitoring systems 3 comprises a monitoring device 6 of a CCD type. For example, this monitoring device 6 is formed of a CCD-chip and the accompanying electronics. Further, each of the digital camera monitoring systems 3 comprises an optical lens system 7 for enlarging the projection of the edges of the wafer 1.

In the embodiment shown in figure 2, the wafer chuck 2 is temperature-controlled by a controlling device 8 which comprises a heat carrier 9. By moving the heat carrier 9 along the surface of the wafer 1, there is performed a heat transport from or to the wafer 1. The controlling device 8 is formed as a part of a cooling circuit with appropriate regulating valves and means for controlling the regulating valves. The controlling device 8 is controlled automatically. Thus, as shown in figure 1, the data processing unit 4 is connected to the controlling device 8 performing a closed-loop temperature control system.

The temperature of the wafer 1, in particular the temperature of the bulk of the wafer 1, can be measured by using the thermal dimensional growth of the wafer 1. In case of heating the wafer 1, the thermal expansion of the wafer 1 can be used to derive the temperature increase. Usually, for a wafer formed on the basis of silicon, the linear thermal expansion coefficient between the temperatures of 25 °C and 400 °C is about α = 2,5 x 10⁻⁶ K⁻¹ up to α = 4,0 x 10⁻⁶ K⁻¹. Therefore, with a wafer diameter of 300 mm there is an average expansion of Δl = 1µm/K. Eventually deposited material layers on the wafer bulk don't have considerable effect concerning the dimensional growth of the wafer 1, because the thickness of the deposited layers is very small compared to the thickness of the wafer bulk.

As mentioned above, the incorporated optical lens systems 7 have the effect of enlarging the projection. With the above-mentioned example of numbers, an enlargement of about 10 to 50 times will lead to a resolution of 10 to 50 µm for measuring 1 K. With this resolution standard CCD elements are applicable. If an accuracy of 10 K is enough for a proper measurement, a lower resolution of 100 to 500 µm is sufficient. In this content, a high resolution means that the CCD elements can achieve a high selection of pixels. So, with a lower resolution, the diameters of the digital monitoring pixels within the CCD elements can be increased.

The thermal expansion of the wafer 1 due to wafer heating shifts the pictures of the edges of the wafer 1 across the CCD elements. This shift could be used to determine the temperature shift of the wafer bulk material. For temperature measurement, the edges of the wafer 1 are located. Thereby, a present wafer edge movement is monitored by the digital camera monitoring systems 3. The data provided by the digital camera monitoring systems 3 containing information about wafer edge movement is processed in the data processing unit 4. With this information, after appropriate calibration processing, wafer temperature can be derived. For calibration, there are necessary at least two CCD elements to compensate for an offset of the wafer diameter or wafer placement.

If the absolute loading temperature of the wafer 1 is obtained before starting the manufacturing process, the absolute wafer temperature during the process can be calculated and monitored.

For improving the contrast of the wafer edges projected to the CCD elements, the arrangement according to figure 1 comprises a light emitting source 10 for illuminating the surface of the wafer 1 opposite to the digital camera monitoring system 3.

## Claims

1. An arrangement for temperature measurement of a semiconductor disk (1) comprising
- a clamping device (2) for holding said disk (1),
- at least two digital camera monitoring systems (3) for locating edges of said disk (1),
- a data processing unit (4) connected to said digital camera monitoring systems (3) for monitoring disk edge movement,
- said digital camera monitoring systems (3) being placed in said clamping device (2) and in different positions of said clamping device (2),
- said digital camera monitoring systems (3) facing towards said disk (1),
- said clamping device (2) having transparent windows (5) being placed in the surface of said clamping device (2) which is turned towards said disk (1), so that the edges of the disk (1) can be located by said digital camera monitoring systems (3).

2. The arrangement according to claim 1,
**characterized in that**
each of said digital camera monitoring systems (3) comprises a monitoring device (6) of a CCD type.

3. The arrangement according to anyone of claims 1 to 2,
**characterized in that**
each of said digital camera monitoring systems (3) comprises an optical lens system (7) for enlarging the projection.

4. The arrangement according to anyone of claims 1 to 3,
**characterized in that**
said clamping device (2) is temperature-controlled by a controlling device (8) comprising a heat carrier (9) performing heat transport from or to said disk (1).

5. The arrangement according to claim 4,
**characterized in that**
said data processing unit (4) is connected to said controlling device (8) performing a closed-loop temperature control system.

6. The arrangement according to anyone of claims 1 to 5,
**characterized in that**
each of said transparent windows (5) is formed of quartz or sapphire.

7. The arrangement according to anyone of claims 1 to 6,
**characterized in that**
the arrangement comprises a light emitting source (10) for illuminating the surface of said disk (1) opposite to said digital camera monitoring systems (3).

8. The arrangement according to anyone of claims 1 to 7,
**characterized in that**
said disk (1) comprises a temperature in the range of 50°C to 500°C.

9. The arrangement according to anyone of claims 1 to 8,
**characterized in that**
said disk (1) is circular shaped and said digital camera monitoring systems (3) are placed in diametrical positions for locating edges said disk (1).

10. The arrangement according to claim 9,
**characterized in that**
said disk (1) is formed as a wafer of at least 300 millimeter in diameter.

11. A method for temperature measurement of a semiconductor disk using the arrangement according to anyone of claims 1 to 10, comprising the steps of:
- calibrating the arrangement to compensate for an offset of disk dimensions and disk placement,
- locating edges of said disk (1) with said digital camera monitoring systems (3),
- monitoring present disk edge movement,
- producing data from said digital camera monitoring systems (3) containing information about disk edge movement,
- processing said data in order to derive disk temperature information.

12. The method according to claim 11,
**characterized in that**
- before starting the manufacturing process the absolute loading temperature of said disk (1) is obtained and
- said data and said absolute loading temperature is processed in order to derive absolute disk temperature.
